(19) Europäisches Patentamt
European Patent Office
Office européen des brevets

(11) **EP 4 579 753 A1**

(12) **EUROPEAN PATENT APPLICATION**
published in accordance with Art. 153(4) EPC

(43) Date of publication:
**02.07.2025 Bulletin 2025/27**

(21) Application number: **22956430.7**

(22) Date of filing: **23.08.2022**

(51) International Patent Classification (IPC):
**H01L 29/06** (2006.01)   **H01L 33/04** (2010.01)

(52) Cooperative Patent Classification (CPC):
**H10D 62/10; H10H 20/811**

(86) International application number:
**PCT/JP2022/031682**

(87) International publication number:
**WO 2024/042602 (29.02.2024 Gazette 2024/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **FUJITSU LIMITED**
**Kawasaki-shi, Kanagawa 211-8588 (JP)**

(72) Inventors:
• **ISHIGURO, Tetsuro**
**Kawasaki-shi, Kanagawa 211-8588 (JP)**

• **KAWAGUCHI, Kenichi**
**Kawasaki-shi, Kanagawa 211-8588 (JP)**
• **MIYATAKE, Tetsuya**
**Kawasaki-shi, Kanagawa 211-8588 (JP)**
• **IWAI, Toshiki**
**Kawasaki-shi, Kanagawa 211-8588 (JP)**
• **DOI, Yoshiyasu**
**Kawasaki-shi, Kanagawa 211-8588 (JP)**
• **SATO, Shintaro**
**Kawasaki-shi, Kanagawa 211-8588 (JP)**

(74) Representative: **Haseltine Lake Kempner LLP**
**Cheapside House**
**138 Cheapside**
**London EC2V 6BJ (GB)**

(54) **QUANTUM DEVICE AND METHOD FOR MANUFACTURING QUANTUM DEVICE**

(57)    A quantum device includes: a waveguide that has a first surface, and extends in a first direction parallel to the first surface; a plurality of nanopillars coupled to the first surface and arranged in the first direction; color centers formed in each of the plurality of nanopillars; and electrode pairs provided for each of the color centers, in which each of the plurality of nanopillars is inclined from the first direction, and extends in a second direction inclined from a normal direction of the first surface, and electric fields are applied to the color centers from the electrode pairs.

FIG. 1

EP 4 579 753 A1

## Description

TECHNICAL FIELD

The present disclosure relates to a quantum device and a method for manufacturing the quantum device.

BACKGROUND ART

In recent years, research and development of quantum computers have been energetically advanced. For example, a quantum computer using a level of an electron spin in a color center of diamond as a qubit is known. In such a quantum computer, electron spin information is converted into photon information, and optical reading is performed.

CITATION LIST

PATENT DOCUMENT

Patent Document 1: U.S. Patent Application Publication No. 2011/0309265
Patent Document 2: U.S. Patent Application Publication No. 2012/0161663
Patent Document 3: Japanese National Publication of International Patent Application No. 2015-529328
Patent Document 4: Japanese National Publication of International Patent Application No. 2007-526639

NON-PATENT DOCUMENT

Non-Patent Document 1: C. T. Nguyen et al., Phys. Rev. Lett. 123, 183602 (2019)
Non-Patent Document 2: A. Sipahigil et al., Science 354, 847 (2016)
Non-Patent Document 3: Ph. Tamarat et al., PHYSICAL REVIEW LETTERS 97, 083002 (2006)
Non-Patent Document 4: L. D. Santis et al., PHYSICAL REVIEW LETTERS 127, 147402 (2021)
Non-Patent Document 5: J. Lisenfeld, npj Quantum Information (2019), 5: 105

SUMMARY OF INVENTION

TECHNICAL PROBLEM

The quantum computer includes a plurality of qubits. At the time of operation, in order to ensure indistinguishability of photons involved in forming entanglement between the plurality of qubits, it is desirable that emission wavelengths of color centers coincide with each other. However, the emission wavelengths of color centers are different in GHz order in terms of frequency due to a defect, distortion, or the like around the color centers. Conventionally, a technique for adjusting the emission wavelength of the color center has been proposed, but it is difficult to place a plurality of qubits with high degree of integration.

An object of the present disclosure is to provide a quantum device capable of improving the degree of integration of qubits and a method for manufacturing the quantum device.

SOLUTION TO PROBLEM

According to an aspect of the present disclosure, there is provided a quantum device including: a waveguide that has a first surface, and extends in a first direction parallel to the first surface; a plurality of nanopillars coupled to the first surface and arranged in the first direction; color centers formed in each of the plurality of nanopillars; and electrode pairs provided for each of the color centers, in which each of the plurality of nanopillars is inclined from the first direction, and extends in a second direction inclined from a normal direction of the first surface, and electric fields are applied to the color centers from the electrode pairs.

ADVANTAGEOUS EFFECTS OF INVENTION

According to the present disclosure, the degree of integration of qubits may be improved.

BRIEF DESCRIPTION OF DRAWINGS

FIG. 1 is a perspective view illustrating a quantum device according to a first embodiment.

FIG. 2 is a plan view illustrating the quantum device according to the first embodiment.

FIG. 3 is a cross-sectional view illustrating the quantum device according to the first embodiment.

FIG. 4 is a cross-sectional view (part 1) illustrating a method for manufacturing the quantum device according to the first embodiment.

FIG. 5 is a cross-sectional view (part 2) illustrating the method for manufacturing the quantum device according to the first embodiment.

FIG. 6 is a cross-sectional view (part 3) illustrating the method for manufacturing the quantum device according to the first embodiment.

FIG. 7 is a cross-sectional view (part 4) illustrating the method for manufacturing the quantum device according to the first embodiment.

FIG. 8 is a cross-sectional view (part 5) illustrating the method for manufacturing the quantum device according to the first embodiment.

FIG. 9 is a cross-sectional view (part 6) illustrating the method for manufacturing the quantum device according to the first embodiment.

FIG. 10 is a cross-sectional view (part 7) illustrating the method for manufacturing the quantum device according to the first embodiment.

FIG. 11 is a cross-sectional view (part 8) illustrating the method for manufacturing the quantum device according to the first embodiment.

FIG. 12 is a plan view (part 1) illustrating the method for manufacturing the quantum device according to the first embodiment.

FIG. 13 is a plan view (part 2) illustrating the method for manufacturing the quantum device according to the first embodiment.

FIG. 14 is a plan view (part 3) illustrating the method for manufacturing the quantum device according to the first embodiment.

FIG. 15 is a plan view (part 4) illustrating the method for manufacturing the quantum device according to the first embodiment.

FIG. 16 is a top view illustrating an example of a method for using the quantum device according to the first embodiment.

FIG. 17 is a cross-sectional view illustrating an example of the method for using the quantum device according to the first embodiment.

FIG. 18 is a diagram (part 1) illustrating a relationship between an intensity F of an electric field and a change amount $\Delta E$ of an optical transition frequency.

FIG. 19 is a diagram (part 2) illustrating a relationship between the intensity F of the electric field and the change amount $\Delta E$ of the optical transition frequency.

FIG. 20 is a diagram illustrating a relationship between a wavelength and transmittance in various metals.

FIG. 21 is a diagram illustrating a quantum operation device according to a second embodiment.

DESCRIPTION OF EMBODIMENTS

Hereinafter, embodiments of the present disclosure will be specifically described with reference to the accompanying drawings. Note that, in the present description and the drawings, constituent elements having substantially the same functional configuration will be given the same reference sign, and redundant explanation will sometimes not be made. In the present disclosure, it is assumed that an X1-X2 direction, a Y1-Y2 direction, and a Z1-Z2 direction are directions orthogonal to each other. A plane including the X1-X2 direction and the Y1-Y2 direction is described as an XY plane, a plane including the Y1-Y2 direction and the Z1-Z2 direction is described as a YZ plane, and a plane including the Z1-Z2 direction and the X1-X2 direction is described as a ZX plane. Note that, for convenience, the Z1-Z2 direction is defined as a vertical direction, where a Z1 side is defined as an upper side, and a Z2 side is defined as a lower side. In addition, a planar view refers to viewing an object from the Z1 side, and a planar shape refers to a shape of an object viewed from the Z1 side.

(First Embodiment)

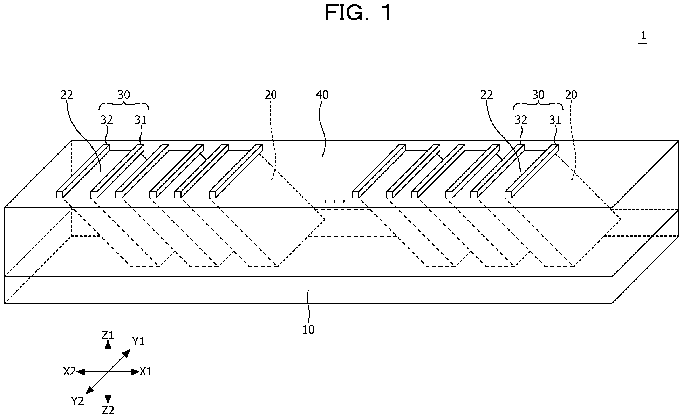

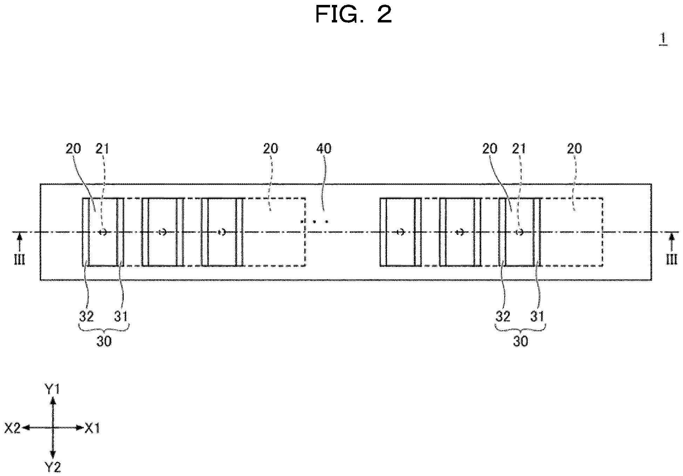

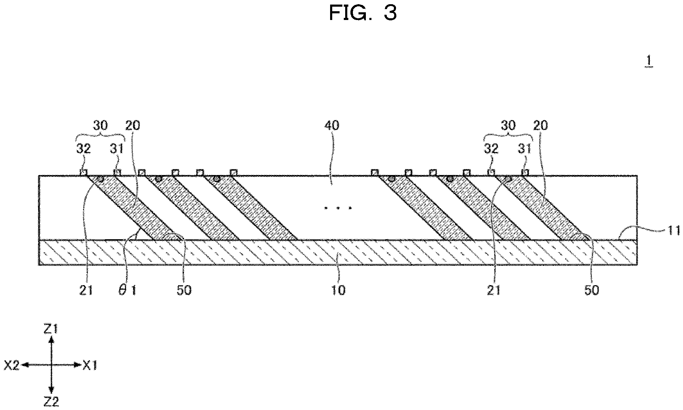

A first embodiment will be described. FIG. 1 is a perspective view illustrating a quantum device according to the first embodiment. FIG. 2 is a plan view illustrating the quantum device according to the first embodiment. FIG. 3 is a cross-sectional view illustrating the quantum device according to the first embodiment. FIG. 3 corresponds to a cross-sectional view taken along line III-III in FIG. 2.

The quantum device 1 according to the first embodiment mainly includes a slab waveguide 10, a plurality of nanopillars 20, a plurality of electrode pairs 30, and an embedded member 40.

The slab waveguide 10 extends in the X1-X2 direction. The slab waveguide 10 has an upper surface 11 perpendicular to the Z1-Z2 direction. The shape of a cross section of the slab waveguide 10 perpendicular to the X1-X2 direction is a rectangular shape. The dimension (height) of this cross section in the Z1-Z2 direction is, for example, about 100 nm. The refractive index of the slab waveguide 10 is lower than the refractive index of diamond. For example, the slab waveguide 10 is made of sapphire, and the upper surface 11 is a c-plane of sapphire. The slab waveguide 10 is an example of a waveguide. The X1-X2 direction is an example of a first direction. The upper surface 11 is an example of a first surface.

The nanopillar 20 is made of diamond. The nanopillar 20 is provided over the upper surface 11 and coupled to the upper surface 11. The plurality of nanopillars 20 is arranged in the X1-X2 direction. The nanopillar 20 extends in a second direction inclined from the X1-X2 direction. For example, the second direction is a direction between the X1-X2 direction and the Z1-Z2 direction, and the nanopillar 20 is inclined toward the X2 side as it goes upward (Z1 side). The second direction is parallel to the [111] direction of diamond. When viewed from a direction perpendicular to the upper surface 11, the second direction overlaps the X1-X2 direction. An angle $\theta1$ formed by the upper surface 11 of the slab waveguide 10 and the second direction is 28.5°. The nanopillar 20 has an upper surface 22 parallel to the upper surface 11 of the slab waveguide 10. For example, the dimension of the upper surface 22 in the X1-X2 direction is about 100 nm, and the dimension of the upper surface 22 in the Y1-Y2 direction is about 200 nm. The distance between the upper surface 11 and the upper surface 22 is, for example, about 250 nm to 1000 nm. The upper surface 22 is the (110) plane of diamond. The shape of a cross section of the nanopillar 20 perpendicular to the second direction is a rectangular shape. This cross section has long sides parallel to the Y1-Y2 direction.

Each of the plurality of nanopillars 20 includes a color center 21. The color center 21 is located in the vicinity of the upper surface 22. For example, the distance from the upper surface 22 to the color center 21 is 100 nm or less. The color center 21 is, for example, a nitrogen-vacancy center (NV center) including a nitrogen atom and a vacancy. That is, the color center 21 is a complex defect of nitrogen atoms and vacancies. The direction in which nitrogen atoms and vacancies are arranged (hereinafter, will be sometimes referred to as a "defect axis direction") is parallel to the [111] direction of diamond. The nanopillars 20 including the color centers 21 can function as qubits.

The embedded member 40 is provided over the upper surface 11 of the slab waveguide 10 and fills a gap between the plurality of nanopillars 20. For example, an upper surface of the embedded member 40 is flush with the upper surfaces 22 of the nanopillars 20. The refractive index of the embedded member 40 is lower than the refractive index of diamond. For example, the embedded member 40 is made of silicon oxide ($SiO_2$). Side surfaces of the nanopillars 20 are in direct contact with the embedded member 40. The nanopillars 20 are surrounded by the embedded member 40.

The electrode pairs 30 are provided for each of the nanopillars 20. The electrode pair 30 includes electrodes 31 and 32. For example, the electrodes 31 and 32 are provided over the embedded member 40. In planar view, the color center 21 is located between the electrodes 31 and 32. When viewed from the color center 21, the electrode 31 is located on the X1 side, and the electrode 32 is located on the X2 side. The material of the electrodes 31 and 32 is not particularly limited, but is preferably a material having less light absorption in a visible light region that is relevant to a signal wavelength. A material of the electrodes 31 and 32 is, for example, gold (Au), silver (Ag), or copper (Cu).

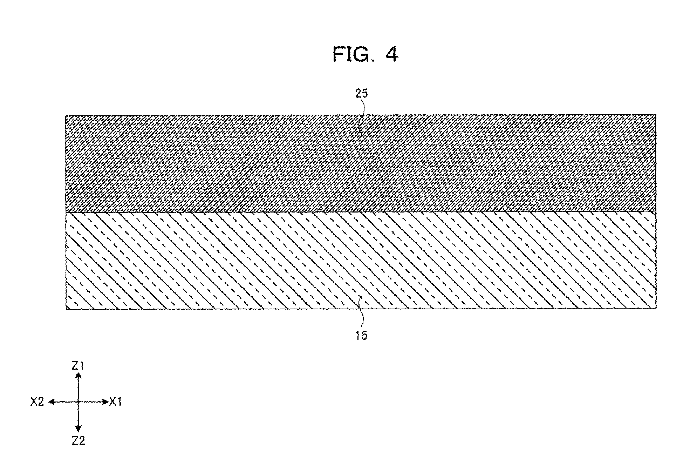

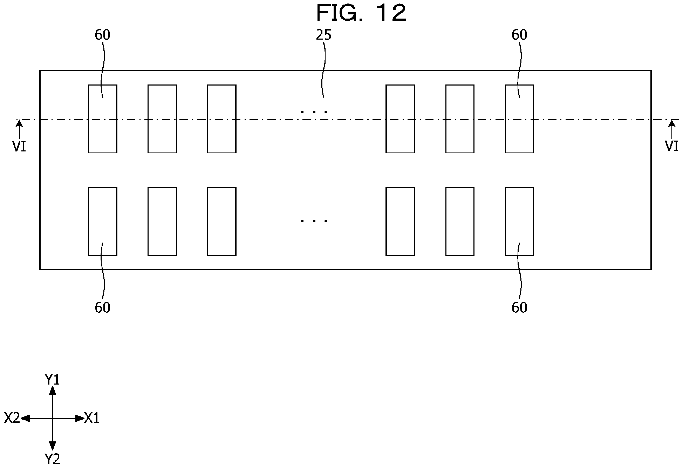

Next, a method for manufacturing the quantum device 1 according to the first embodiment will be described. FIGs. 4 to 11 are cross-sectional views illustrating the method for manufacturing the quantum device 1 according to the first embodiment. FIGs. 12 to 15 are plan views illustrating the method for manufacturing the quantum device 1 according to the first embodiment.

First, as illustrated in FIG. 4, a sapphire substrate 15 and a diamond substrate 25 are prepared, and an upper surface of the sapphire substrate 15 and a lower surface of the diamond substrate 25 are bonded. The sizes of the sapphire substrate 15 and the diamond substrate 25 are assumed, for example, to be sizes that allow a plurality of quantum devices 1 to be formed in the Y1-Y2 direction. For example, the upper surface of the sapphire substrate 15 is made to have the c-plane, and the upper surface of the diamond substrate 25 is made to have the (110) plane. As the diamond substrate 25, for example, a high-quality synthetic diamond substrate is used. As the bonding, room-temperature bonding without using a sizing agent, such as surface-activated room-temperature bonding, is desirable. In the surface-activated room-temperature bonding, the upper surface of the sapphire substrate 15 and the lower surface of the diamond substrate 25 are brought into an active state, that is, a state in which dangling bonds are exposed, using argon ions or the like in vacuum, and the upper surface of the sapphire substrate 15 and the lower surface of the diamond substrate 25 are affixed to each other. Bonding using a sizing agent having no absorption band in the visible light region may be performed. The sapphire substrate 15 is an example of a first substrate, and the diamond substrate 25 is an example of a second substrate.

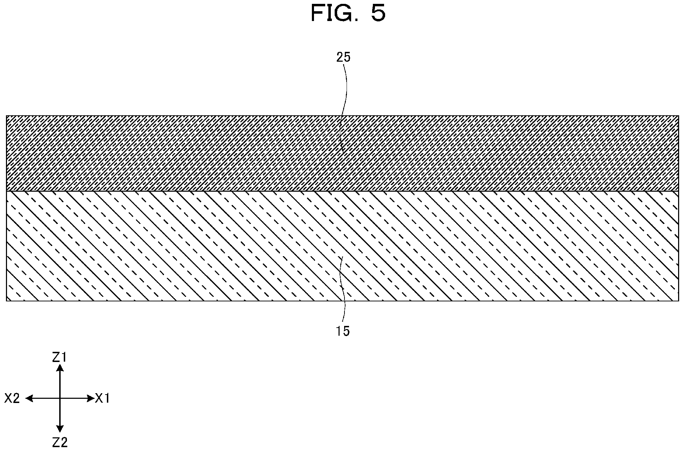

The diamond substrate 25 is then polished to make the thickness of the diamond substrate 25 coincident with the distance between the upper surfaces 22 of the nanopillars 20 and the upper surface 11 of the slab waveguide 10, as illustrated in FIG. 5. The polishing is, for example, mechanical polishing, chemical mechanical polishing, dry etching, or the like.

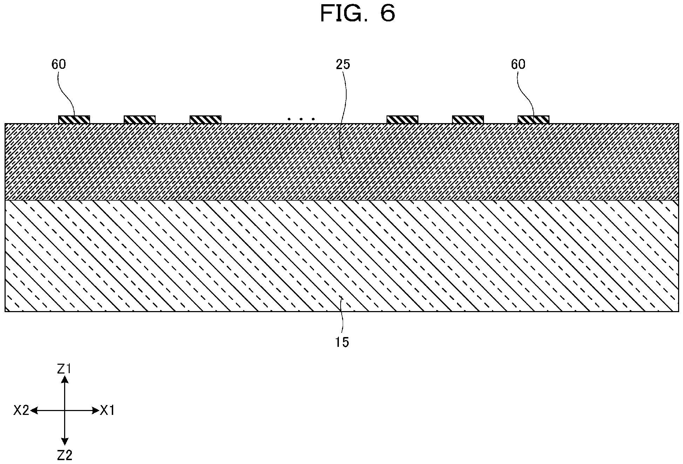

Thereafter, as illustrated in FIGs. 6 and 12, a mask 60 is formed over portions of the upper surface of the diamond substrate 25 intended to constitute the upper surfaces 22 of the nanopillars 20. The mask 60 is, for example, a silicon nitride (SiN) film. The mask 60 can be formed by, for example, photolithography. FIG. 6 corresponds to a cross-sectional view taken along line VI-VI in FIG. 12.

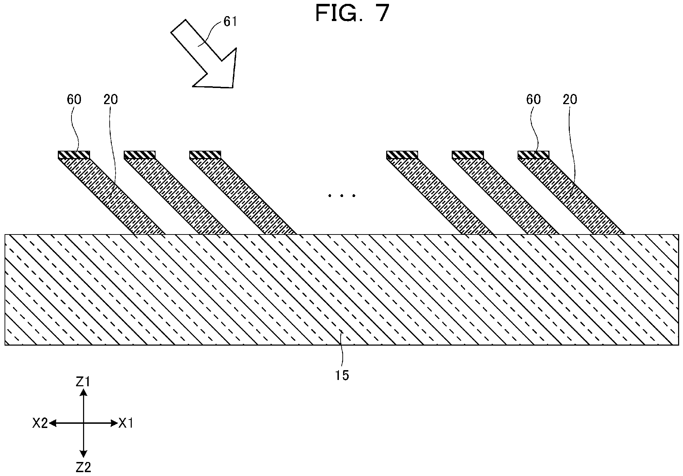

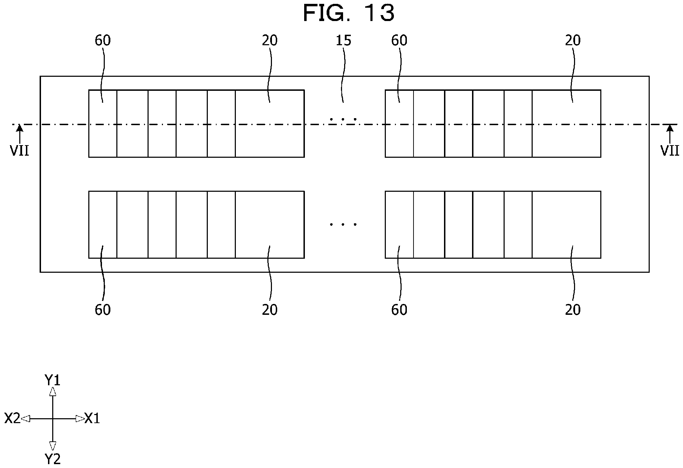

Subsequently, as illustrated in FIGs. 7 and 13, a plurality of nanopillars 20 is formed from the diamond substrate 25 by reactive ion etching (RIE) using oxygen ($O_2$) ions 61 incident from a direction parallel to the [111] direction of the diamond substrate 25. In this RIE, for example, the upper surface of the diamond substrate 25 is inclined by 28.5° with respect to the incident direction of the $O_2$ ions 61. The nanopillars 20 are formed so as to extend parallel to the [111] direction of diamond. By using the SiN film as the mask 60, high tolerance can be obtained. FIG. 7 corresponds to a cross-sectional view taken along line VII-VII in FIG. 13.

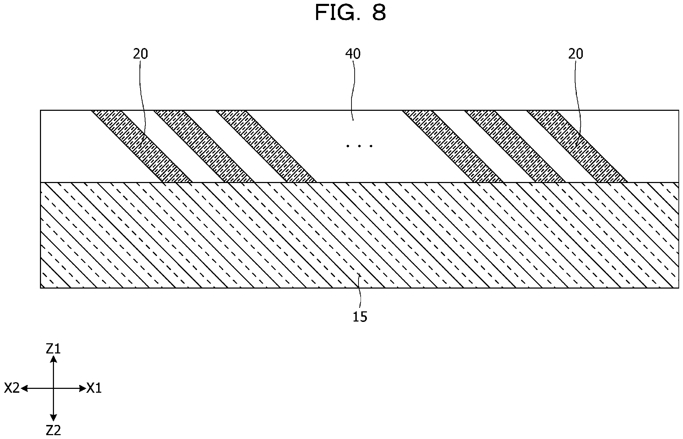

As illustrated in FIG. 8, the mask 60 is then removed, and the embedded member 40 is formed. The embedded member 40 can be formed by, for example, a chemical vapor deposition (CVD) method.

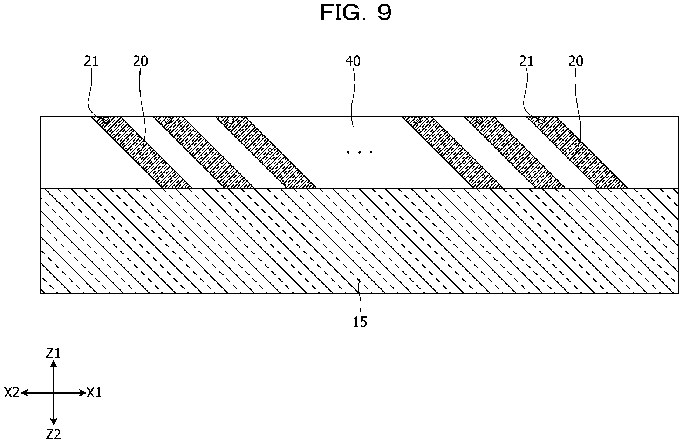

Thereafter, as illustrated in FIG. 9, the color centers 21 are formed in each nanopillar 20. In a case of forming the NV center, ion implantation with nitrogen ions is performed. At the time of ion implantation, an acceleration voltage is adjusted such that the color center 21 can be formed in the vicinity of the upper surface 22 of the nanopillar 20. In addition, for example, the dose amount is defined as $10^{10}/cm^2$ or less. In this case, several levels of color centers 21 are formed for each of the nanopillars 20. Then, after the ion implantation, an annealing treatment at 1000°C or higher is performed in vacuum or in an inert gas atmosphere. For example, the treatment time is desirably set such that the luminescence characteristics of the color centers 21 (luminescence intensity per color center 21) are optimized.

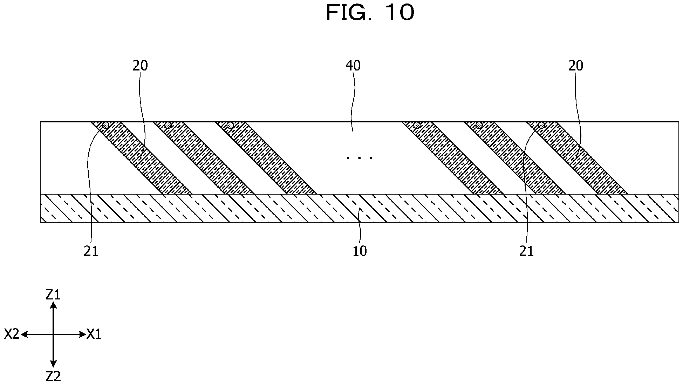

Subsequently, as illustrated in FIG. 10, the sapphire substrate 15 is thinned, and the slab waveguide 10 is formed from the sapphire substrate 15. The thickness of the slab waveguide 10 is defined as, for example, about 100 nm.

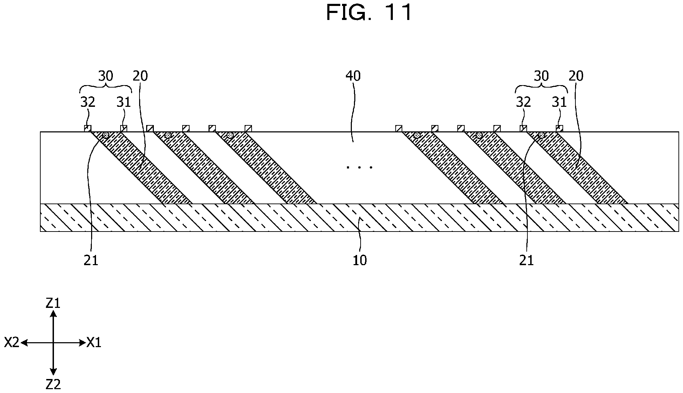

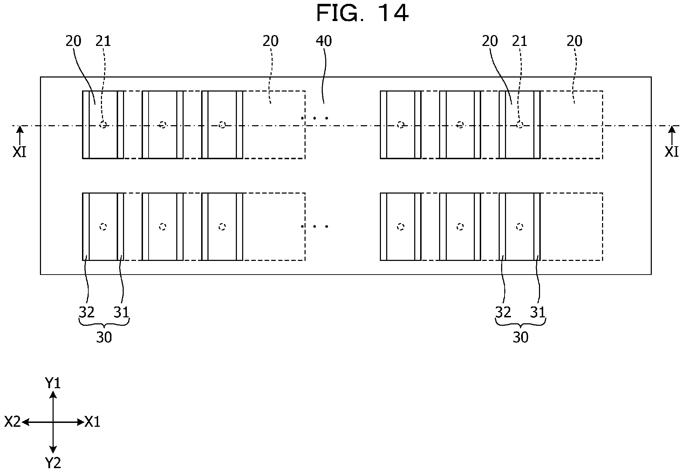

As illustrated in FIGs. 11 and 14, the electrode pairs 30 including the electrodes 31 and 32 are then formed for each of the nanopillars 20. At this time, wiring (not illustrated) coupled to the electrode pairs 30 is also formed. The electrode pairs 30 and the wiring are formed over the embedded member 40. FIG. 11 corresponds to a cross-sectional view taken along line XI-XI in FIG. 14.

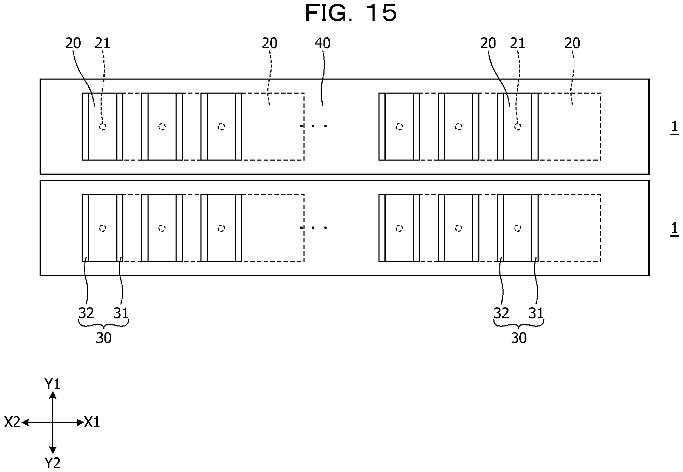

Thereafter, as illustrated in FIG. 15, the structure illustrated in FIGs. 11 and 14 is divided in the Y1-Y2 direction to obtain a plurality of quantum devices 1. The division can be performed by, for example, laser ablation or a dry process.

The quantum device 1 according to the first embodiment can be manufactured in this manner.

Note that the color center 21 may be a silicon-vacancy center (SiV center) including silicon and a vacancy, a germanium-vacancy center (GeV center) including germanium and a vacancy, a tin-vacancy center (SnV center) including tin and a vacancy, a lead-vacancy center (PbV center) including lead and a vacancy, or a boron-vacancy center (BV center) including boron and a vacancy.

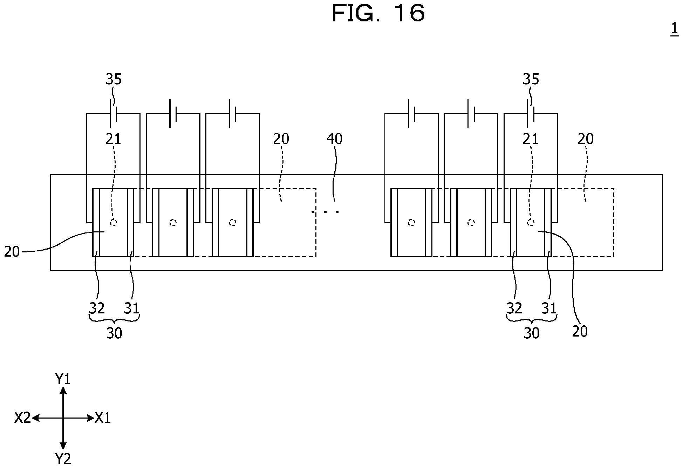

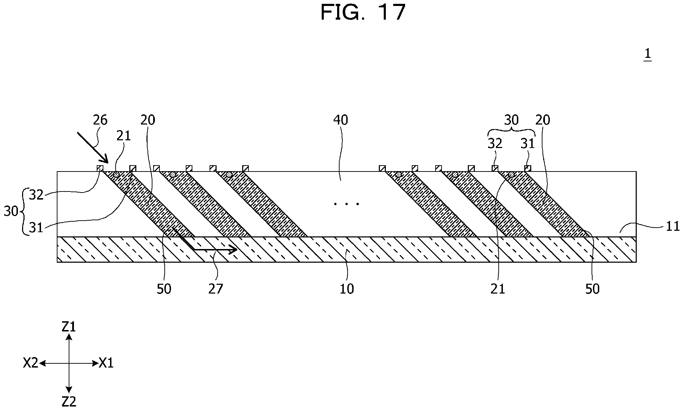

Here, an example of a method for using the quantum device 1 according to the first embodiment will be described. FIG. 16 is a top view illustrating an example of a method for using the quantum device 1 according to the first embodiment. FIG. 17 is a cross-sectional view illustrating an example of the method for using the quantum device 1 according to the first embodiment.

In this example, as illustrated in FIG. 16, direct current (DC) power supplies 35 are individually coupled to each electrode pair 30. For example, a negative electrode of the DC power supply 35 is coupled to the electrode 31, and a positive electrode of the DC power supply 35 is coupled to the electrode 32. Therefore, an electric field is applied to the color center 21 from the electrode pair 30. This electric field includes a component perpendicular to a defect axis of the color center 21 (hereinafter, will be sometimes referred to as a "perpendicular component"). In addition, as illustrated in FIG. 17, the color center 21 is irradiated with a laser beam 26 in the visible light region. The wavelength of the laser beam 26 is, for example, 520 nm to 720 nm.

The color center 21 emits light when irradiated with the laser beam 26. Since the nanopillar 20 is surrounded by the embedded member 40 having a refractive index lower than that of diamond, light generated at the color center 21 is confined in the nanopillar 20. Then, this light propagates through the nanopillar 20 as signal light 27 along the second direction (a direction parallel to the [111] direction of diamond) in which the nanopillar 20 extends. At this time, the signal light 27 propagates through the nanopillar 20 in a single mode only with the transverse electric (TE) mode having an electric field amplitude component only in the direction (Y1-Y2 direction) parallel to the long sides of the cross section of the nanopillar 20 perpendicular to the second direction. That is, the signal light 27 undergoes single-mode propagation through the nanopillar 20 in the second direction.

In addition, in the present embodiment, the total reflection angle at an interface 50 between the diamond nanopillar 20 and the slab waveguide 10 made of sapphire is 46.8°, whereas the angle θ1 formed by the traveling direction of the signal light 27 in the nanopillar 20 and the interface 50 is 28.5°. That is, the angle θ1 is less than the total reflection angle. Therefore, the signal light 27 propagated to the interface 50 is guided to the slab waveguide 10 from the nanopillar 20 with high efficiency. Furthermore, the signal light 27 guided into the slab waveguide 10 propagates through the slab waveguide 10 while maintaining the single mode of the TE mode.

In addition, the electrode pairs 30 and the wiring are formed over the embedded member 40. Accordingly, compared with a case where the electrode pair 30 or the wiring made of metal is formed over the nanopillar 20, the signal light 27 is easily confined in the nanopillar 20, and the optical loss caused by metal may be reduced.

Here, control for the wavelength of the signal light 27 will be described. In the present embodiment, the electric field having the perpendicular component can be applied to the color center 21. When such an electric field is applied, the optical transition wavelength in the color center 21 changes due to the Stark effect. The change amount $\Delta E$ in the optical transition frequency is expressed by following formula (1) when the intensity of the perpendicular component of the electric field is assumed as F and the second-order term of F is inclusively considered.

$$\Delta E = -\Delta\mu F - \frac{1}{2}\Delta\alpha F^2 = -\Delta\mu(E(\varepsilon+2)/3) - \frac{1}{2}\Delta\alpha(E(\varepsilon+2)/3)^2 \qquad \cdots (1)$$

[Mathematical Formula 1]

In mathematical formula 1, $\Delta\mu$ denotes a change amount of dipole moment between the ground level and the excitation level, $\Delta\alpha$ denotes a change amount of polarizability tensor between the ground level and the excitation level, and $\varepsilon$ denotes the relative permittivity of diamond.

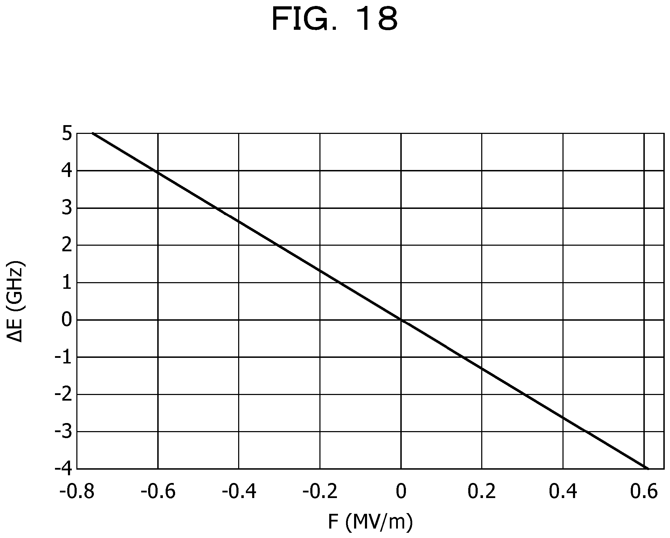

In a case where the color center 21 is the NV center, there is a relationship illustrated in FIG. 18 between the intensity F of the perpendicular component and the change amount $\Delta E$ of the optical transition frequency. Since the NV center has low symmetry in the defect axis direction, $\Delta\alpha$ has substantially 0 Å$^3$, and $\Delta E$ is expressed by a linear formula of F. When using the value of $\Delta\mu$ ($4.329 \times 10^{-30}$ C·m) obtained from the description of Non-Patent Document 3, the result that $\Delta E$ could be changed by about 5 GHz by changing the intensity F of the perpendicular component by about 1.0 MV/m was obtained, as illustrated in FIG. 18.

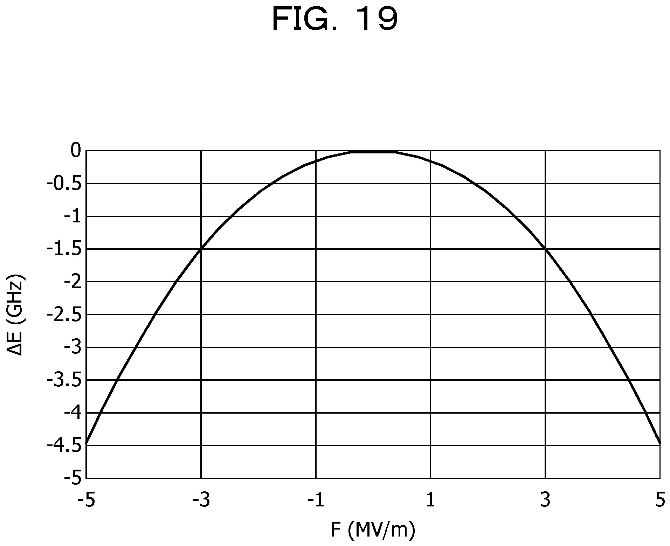

In a case where the color center 21 is the SnV center, there is a relationship illustrated in FIG. 19 between the intensity F of the perpendicular component and the change amount $\Delta E$ of the optical transition frequency. Since the SnV center has high symmetry in the defect axis direction, $\Delta E$ is insensitive to the first-order term of F and is greatly affected by the second-order term of F. When using the value of $\Delta\mu$ (($1.332 \times 10^{-24}$ C·m) and the value of $\Delta\alpha$ (0.23 Å$^3$) obtained from the description of Non-Patent Document 4, the result that $\Delta E$ could be changed by about 5 GHz by changing the intensity F of the perpendicular component by about 1.0 MV/m was obtained, as illustrated in FIG. 19.

From these results, it may be said that the optical transition frequency of the color center 21 can be adjusted in a range of about 5 GHz by applying the electric field using the electrode pair 30. In other words, it may be said that the emission wavelength in the color center 21 can be adjusted.

In addition, in the present embodiment, since the plurality of nanopillars 20 and the slab waveguide 10 overlap in the Z1-Z2 direction, the degree of integration may be improved, as compared with a configuration in which a qubit and a waveguide are placed in one plane.

For example, it is assumed that the dimension of the upper surface 22 is 100 nm, the dimensions of the electrodes 31 and 32 are 30 nm, and the distance between the adjacent upper surfaces 22 is 200 nm in the X1-X2 direction, and the dimension of the upper surface 22 in the Y1-Y2 direction is 200 nm. In this case, in a plane including each upper surface 22, the dimension of a region for securing two qubits is 460 nm in the X1-X2 direction, the dimension thereof is 200 nm in the Y1-Y2 direction, and the area thereof is 0.092 $\mu$m$^2$. Therefore, the occupied area per qubit is 0.046 $\mu$m$^2$. On the other hand, the occupied area per qubit of the superconducting quantum computer described in Non-Patent Document 5 is 90,000 $\mu$m$^2$. In other words, according to the present embodiment, the occupied area per qubit can be formed smaller by approximately seven digits.

As described above, in the present embodiment, since the nanopillars 20 partially overlap each other in the Z1-Z2 direction, the interval between the nanopillars 20 in a plane parallel to the upper surface 11 can be narrowed, and the degree of integration of qubits may be improved.

According to the present embodiment, both of adjustment of the emission wavelengths of the color centers 21 and improvement in the degree of integration of qubits may be achieved. By improving the degree of integration, the scale of an optical circuit including the color centers 21 may be increased.

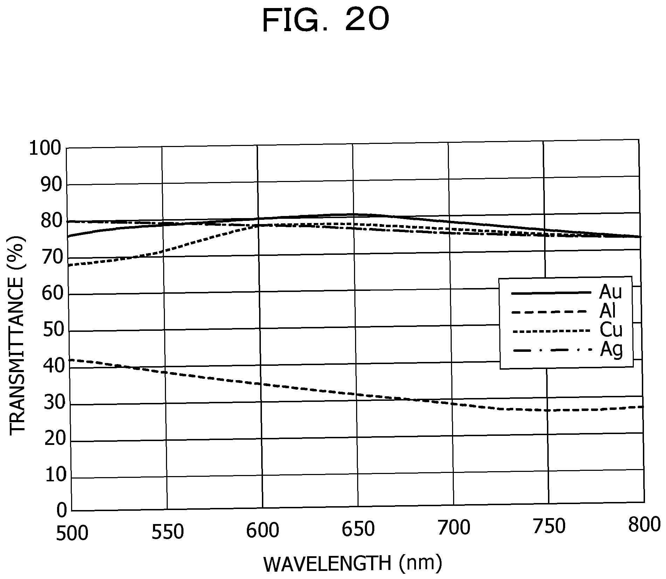

The electrodes 31 and 32 included in the electrode pair 30 are preferably made of a material having less light absorption in the visible light region. FIG. 20 is a diagram illustrating a relationship between a wavelength and transmittance in various metals. FIG. 20 illustrates the transmittance of Au, Ag, Cu, and aluminum (Al) films having a thickness of 5 nm calculated using the Drude model. As illustrated in FIG. 20, a higher transmittance than that of Al can be obtained with Au, Ag, or Cu.

Note that the second direction does not have to be parallel to the [111] direction of diamond. The angle θ1 is preferably less than the total reflection angle at the interface 50.

(Second Embodiment)

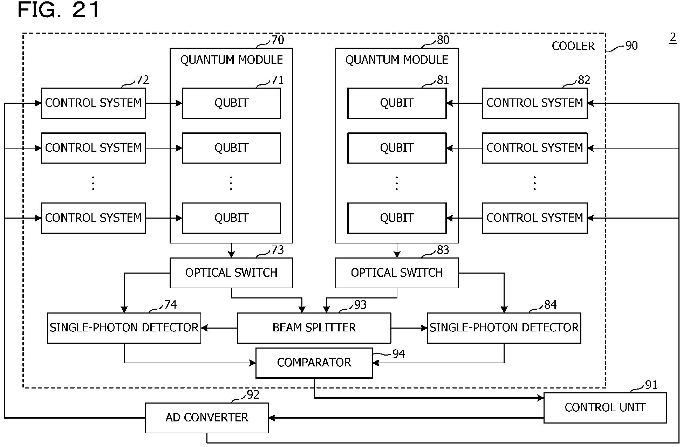

A second embodiment will be described. FIG. 21 is a diagram illustrating a quantum operation device according to the second embodiment. The quantum operation device 2 functions as a quantum computer.

The quantum operation device 2 according to the second embodiment includes quantum modules 70 and 80, a plurality of control systems 72 and 82, optical switches 73 and 83, and single-photon detectors 74 and 84. The quantum operation device 2 further includes a cooler 90, a control unit 91, an analog-to-digital (AD) converter 92, a beam splitter 93, and a comparator 94. The quantum modules 70 and 80, the control systems 72 and 82, the optical switches 73 and 83, the single-photon detectors 74 and 84, the AD converter 92, the beam splitter 93, and the comparator 94 are housed inside the cooler 90. The temperature inside the cooler 90 is 4 K or less.

The control unit 91 outputs an analog signal for control to the AD converter 92, the AD converter 92 converts the analog signal into a digital signal, and the digital signal is input to the control systems 72 and 82. The control unit 91 is, for example, a personal computer.

As the quantum modules 70 and 80, the quantum device 1 according to the first embodiment is used. The quantum module 70 includes a plurality of qubits 71, and the quantum module 80 includes as many qubits 81 as the qubits 71. The qubits 71 and 81 correspond to the nanopillars 20 including the color centers 21 in the quantum device 1. The control systems 72 are provided for each of the qubits 71, and the control systems 82 are provided for each of the qubits 81. The control systems 72 each control a magnetic field, an electric field, and a microwave applied to the corresponding qubit 71 and irradiates the corresponding qubit 71 with a laser beam. The control systems 82 each control a magnetic field, an electric field, and a microwave applied to the corresponding qubit 81 and irradiates the corresponding qubit 81 with a laser beam. The application of the magnetic field is used to form a state of the color center 21 in which the quantum manipulation is performed. The application of the microwave is used to control a state of the color center 21. The irradiation of the laser beam is used to read a state of the color center 21 (single photon generation). The application of the electric field is used to control the emission wavelength of the color center 21. In the control for the electric field, the electric field is controlled via the electrode pair 30.

The signal light (photon) generated by the quantum module 70 is input to the optical switch 73, and the optical switch 73 outputs the signal light to the single-photon detector 74 or the beam splitter 93. In addition, the signal light (photon) generated by the quantum module 80 is input to the optical switch 83, and the optical switch 83 outputs the signal light to the single-photon detector 84 or the beam splitter 93. The signal light input to the beam splitter 93 is output to the single-photon detectors 74 and 84. In this manner, the path of the signal light generated by the quantum module 70 is switched by the optical switch 73 between a path directly guided to the single-photon detector 74 and a path guided to the single-photon detector 74 by way of the beam splitter 93. Similarly, the path of the signal light generated by the quantum module 80 is switched by the optical switch 83 between a path directly guided to the single-photon detector 84 and a path guided to the single-photon detector 84 by way of the beam splitter 93.

For example, at the time of reading a state of a single qubit, the signal light is directly guided to the single-photon detector 74 or 84 from the quantum module 70 or 80 by the optical switch 73 or 83. For example, during an entanglement operation between spins of color centers corresponding to a multi-gate operation, the signal light is guided to the single-photon detector 74 or 84 from the quantum module 70 or 80 by way of the beam splitter 93 by the optical switch 73 or 83. At this time, the nanopillars 20 having identical optical path lengths from the beam splitter 93 are used between the quantum modules 70 and 80.

The comparator 94 is used at the time of an entanglement operation and compares detection signals for a single photon after being branched by the beam splitter 93 (which of the single-photon detector 74 or 84 detects the single photon in what order). The result of analyzing the output from the comparator 94 corresponds to the result of operation by the quantum operation device 2.

Note that a spectrometer is not used to adjust the emission wavelengths between the quantum modules 70 and 80, and the emission wavelengths are adjusted according to the electric fields applied using the electrode pairs 30 while monitoring quantum interference (Hong-Ou-Mandel (HOM) interference) between two photons. The HOM interference is a phenomenon in which, when photons are incident on a beam splitter separately from two ports, the photons are detected only by one detector any time.

According to the quantum operation device 2 configured as described above, since the quantum device 1 according to the first embodiment is used for the quantum modules 70 and 80, the degree of integration of qubits may be improved. In addition, a practical quantum operation device 2 with high reliability may be obtained.

Although the preferred embodiments and the like have been described in detail so far, the embodiments are not restricted to the above-described embodiments and the like, and various modifications and substitutions can be made to the embodiments and the like described above, without departing from the scope disclosed in the claims.

   1: quantum device

2: quantum operation device
10: slab waveguide
11: upper surface
15: sapphire substrate
20: nanopillar
21: color center
22: upper surface
25: diamond substrate
30: electrode pair
31, 32: electrodes
40: embedded member
50: interface

**Claims**

1. A quantum device comprising:

   a waveguide that has a first surface, and extends in a first direction parallel to the first surface;
   a plurality of nanopillars coupled to the first surface and arranged in the first direction;
   color centers formed in each of the plurality of nanopillars; and
   electrode pairs provided for each of the color centers, wherein
   each of the plurality of nanopillars is inclined from the first direction, and extends in a second direction inclined from a normal direction of the first surface, and
   electric fields are applied to the color centers from the electrode pairs.

2. The quantum device according to claim 1, comprising an embedded member that is provided over the first surface, and fills a gap between the plurality of nanopillars.

3. The quantum device according to claim 2, wherein a material of the nanopillars is diamond, and a refractive index of the embedded member is lower than the refractive index of the diamond.

4. The quantum device according to claim 2 or 3, wherein the electrode pairs are provided over the embedded member.

5. The quantum device according to claim 1 or 2, wherein a material of the nanopillars is diamond, and a refractive index of the waveguide is lower than the refractive index of the diamond.

6. The quantum device according to claim 1 or 2, wherein the first direction and the second direction overlap when the first surface is viewed from the normal direction.

7. The quantum device according to claim 1 or 2, wherein an angle formed by the first surface and the second direction is less than a total reflection angle at an interface between the waveguide and the nanopillars.

8. The quantum device according to claim 1 or 2, wherein the electric fields include a component perpendicular to a direction in which atoms and vacancies that constitute the color centers are arranged.

9. The quantum device according to claim 1 or 2, wherein

   a shape of a cross section of the nanopillars perpendicular to the second direction is a rectangular shape, and
   light that propagates through the nanopillars undergoes a single-mode propagation in the second direction.

10. The quantum device according to claim 9, wherein the light that propagates through the nanopillars has an electric field amplitude component only in a direction parallel to a long side of the cross section.

11. The quantum device according to claim 1 or 2, wherein the color centers include a complex defect of nitrogen (N), silicon (Si), germanium (Ge), tin (Sn), or lead (Pb), or any combination of the N, Si, Ge, Sn, or Pb, and vacancies.

12. The quantum device according to claim 1 or 2, wherein the electrode pairs contain gold (Au), silver (Ag), or copper (Cu).

**13.** A method for manufacturing a quantum device, comprising:

a process of bonding a second substrate that has a refractive index higher than the refractive index of a first substrate, to a first surface of the first substrate;
a process of processing the second substrate to form a plurality of nanopillars arranged in a first direction parallel to the first surface;
a process of forming color centers in each of the plurality of nanopillars; and
a process of forming electrode pairs for each of the color centers, wherein
each of the plurality of nanopillars is inclined from the first direction, and extends in a second direction inclined from a normal direction of the first surface, and
electric fields are applied to the color centers from the electrode pairs.

FIG. 1

# FIG. 2

FIG. 3

FIG. 4

25

15

Z1

X2 ← → X1

Z2

FIG. 5

# FIG. 6

60                    25                   60

15

Z1

X2 ←→ X1

Z2

FIG. 7

FIG. 8

# FIG. 9

21  20                    40                         21  20

. . .

15

Z1
X2 ← → X1
Z2

FIG. 10

FIG. 11

## FIG. 12

## FIG. 13

60    20    15    60    20

VII                                                VII

60    20         60    20

Y1
X2 ← → X1
Y2

## FIG. 14

# FIG. 15

## FIG. 16

1

FIG. 17

# FIG. 18

# FIG. 19

# FIG. 20

FIG. 21

## INTERNATIONAL SEARCH REPORT

| | International application No. |
|---|---|
| | **PCT/JP2022/031682** |

| A. | CLASSIFICATION OF SUBJECT MATTER |
|---|---|

*H01L 29/06*(2006.01)i; *H01L 33/04*(2010.01)i
FI:    H01L29/06 601Q; H01L33/04

According to International Patent Classification (IPC) or to both national classification and IPC

| B. | FIELDS SEARCHED |
|---|---|

Minimum documentation searched (classification system followed by classification symbols)

H01L29/06; H01L33/04

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | VOLKOVA, Kseniia et al. Optical and Spin Properties of NV Center Ensembles in Diamond Nano-Pillars. Nanomaterials. 29 April 2022, 12, 1516<br>entire text, all drawings | 1-13 |
| A | AGHAEIMEIBODI, Shahriai et al. Electrical Tuning of Tin-Vacancy Centers in Diamond. PHYSICAL REVIEW APPLIED. 03 June 2021, 15, 064010<br>entire text, all drawings | 1-13 |
| A | AGHAEIMEIBODI, S. et al. Quantum Photonics with SnV Centers in Diamond. 2021 IEEE International Electron Devices Meeting (IEDM). 09 March 2022, 2021, 14.6.1-14.6.4<br>entire text, all drawings | 1-13 |
| A | WO 2022/118366 A1 (FUJITSU LTD) 09 June 2022 (2022-06-09)<br>entire text, all drawings | 1-13 |
| A | US 2011/0309265 A1 (BABINEC, Thomas M.) 22 December 2011 (2011-12-22)<br>entire text, all drawings | 1-13 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **21 October 2022** | **01 November 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

International application No.

**PCT/JP2022/031682**

| C. | DOCUMENTS CONSIDERED TO BE RELEVANT | |
|---|---|---|
| Category* | Citation of document, with indication, where appropriate, of the relevant passages | Relevant to claim No. |
| A | JP 2015-529328 A (PRESIDENT AND FELLOWS OF HARVARD COLLEGE) 05 October 2015 (2015-10-05)<br>  entire text, all drawings | 1-13 |
| A | JP 2007-526639 A (THE UNIVERSITY OF MELBOURNE) 13 September 2007 (2007-09-13)<br>  entire text, all drawings | 1-13 |

Form PCT/ISA/210 (second sheet) (January 2015)

## INTERNATIONAL SEARCH REPORT
### Information on patent family members

International application No.

**PCT/JP2022/031682**

| Patent document cited in search report | | | Publication date (day/month/year) | Patent family member(s) | | | Publication date (day/month/year) |
|---|---|---|---|---|---|---|---|
| WO | 2022/118366 | A1 | 09 June 2022 | (Family: none) | | | |
| US | 2011/0309265 | A1 | 22 December 2011 | (Family: none) | | | |
| JP | 2015-529328 | A | 05 October 2015 | US | 2015/0253355 | A1 | |
| | | | | entire text, all drawings | | | |
| | | | | EP | 2888596 | A1 | |
| | | | | CN | 104704375 | A | |
| JP | 2007-526639 | A | 13 September 2007 | US | 2007/0277730 | A1 | |
| | | | | entire text, all drawings | | | |
| | | | | EP | 1735659 | A1 | |
| | | | | KR | 10-2007-0004012 | A | |
| | | | | CN | 1969227 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110309265
- US 20120161663
- JP 2015529328 A
- JP 2007526639 A

**Non-patent literature cited in the description**

- **C. T. NGUYEN et al.** *Phys. Rev. Lett.*, 2019, vol. 123, 183602
- **A. SIPAHIGIL et al.** *Science*, 2016, vol. 354, 847
- **PH. TAMARAT et al.** *PHYSICAL REVIEW LETTERS*, 2006, vol. 97, 083002
- **L. D. SANTIS et al.** *PHYSICAL REVIEW LETTERS*, 2021, vol. 127, 147402
- **J. LISENFELD.** *npj Quantum Information*, 2019, vol. 5, 105